# EUROPÄISCHE PATENTSCHRIFT

(11) **EP 1 862 564 B1**
(45) Veröffentlichungstag und Bekanntmachung des Hinweises auf die Patenterteilung: **03.09.2008**
(21) Anmeldenummer: 06011585.4
(22) Anmeldetag: 03.06.2006
(51) Int. Cl.: C23C 14/24, C23C 14/26

(54) **Vorrichtung zum Verdampfen von Materialien mit einem Verdampferrohr**
Apparatus for the evaporation of materials by means of an evaporator tube
Dispositif d'évaporation des matériaux par un tube d'évaporation

(43) Veröffentlichungstag der Anmeldung: 05.12.2007
(73) Patentinhaber: Applied Materials GmbH & Co. KG, 63755 Alzenau (DE)
(72) Erfinder: Hattendorf, Guido, 63636 Brachttal (DE)
(74) Vertreter: Schickedanz, Willi

(56) Entgegenhaltungen:
- DE-B- 1 290 409
- JP-A- 61 078 463
- US-A1- 2002 108 572

## Beschreibung

Die Erfindung betrifft eine Vorrichtung zum Verdampfen von Materialien nach dem Oberbegriff des Patentanspruchs 1.

Beschichtungsprozesse für das Aufbringen von Schichten auf Substraten stellen in der Industrie eine nicht mehr wegzudenkende Fertigungstechnik dar. Die auf diese Substrate aufgetragenen Schichten können zum Beispiel als Schutzschichten oder auch nur als dekorative Schichten dienen.

Als Beispiel eines solchen Beschichtungsprozesses ist der Verdampfungsprozess zu nennen. Bei einem solchen Verdampfungsprozess werden in einer Verdampfervorrichtung Materialien eingebracht und anschließend in die Gasphase überführt. Diese gasförmigen Materialien bewegen sich dann in Richtung eines Substrats, wo sie sich niederschlagen und so eine sehr gleichmäßige Schicht bilden. Nachdem eine solche erste Schicht aufgetragen worden ist, können natürlich auf diesem Wege noch weitere Schichten aufgebracht werden, sodass es auch möglich ist, Mehrschichtsysteme auf einem Substrat aufzubringen.

So ist ein Beschichtungsprozess bekannt, bei dem in einer Vakuumkammer ein Substrat mit dampfförmigem organischem Material beschichtet wird (EP 1 401 036 A2). Die Beschichtungskammer verfügt über mehrere nebeneinander angeordnete Verdampferquellen, die mit einem mit Düsen versehenen Dampfauslass verbunden sind, über die der Dampf in Richtung des Substrats wandern kann, um sich dort niederzuschlagen. Dabei ist zwischen jeder Verdampferquelle und dem Dampfauslass jeweils ein Ventil vorgesehen, mit dem die Menge an ausströmendem Dampf eingestellt werden kann.

Weiterhin ist eine Verdampfervorrichtung zum Beschichten eines Substrats bekannt, die über eine Beschichtungskammer mit einem Substrat verfügt (US 2005/0241585 A1). Diese Verdampfervorrichtung weist ferner mindestens zwei separat voneinander angeordnete Verdampferquellen auf, die über Mittel verfügen, mit denen die in die Beschichtungskammer ausströmende Dampfmenge individuell gesteuert werden kann.

Ferner ist eine Verdampfervorrichtung mit mehreren separat neben einander liegenden Verdampferquellen (US 6 770 562 B2) bekannt. Oberhalb dieser Verdampferquellen ist eine Beschichtungskammer angeordnet, in der sich das Substrat befindet. Dabei ist die Beschichtungskammer in mehrere Sektionen aufgeteilt, die das Substrat nacheinander durchläuft. Jede dieser Sektionen ist mit je einer Verdampferquelle verbunden, sodass das Substrat nacheinander von dem die Verdampferquellen verlassenden Dampf beschichtet wird. Ein zwischen den Sektionen und den Verdampferquellen angeordnetes Ventil dient zur Steuerung der Menge an ausströmendem Dampf.

Aufgabe der vorliegenden Erfindung ist es, die thermische Belastung des zu verdampfenden Materials trotz einer langen Standzeit der Vorrichtung zum Verdampfen von Material zu reduzieren.

Diese Aufgabe wird gemäß den Merkmalen des Patentanspruchs 1 gelöst.

Die Erfindung betrifft somit eine Vorrichtung zum Verdampfen von Materialien mit einem Verdampferrohr oder dergleichen, das wenigstens einen Austritt für das verdampfte Material aufweist. Das Verdampferrohr ist dabei mit einem Dampf-Verteiler verbunden und weist wenigstens zwei separat beheizbare Verdampfereinheiten auf. In dem Verdampferrohr sind ein oberer und ein unterer Kolben vorgesehen, die durch einen Spalt getrennt sind. Die wenigstens zwei separaten Verdampfereinheiten umgeben den unteren und/oder den oberen Kolben zumindest teilweise zangenartig.

Ein Vorteil der Erfindung besteht darin, dass auch Materialien verdampft werden können, die thermisch nicht über einen längeren Zeitraum stabil bleiben. Das Material wird dazu in kleinen Portionen verdampft. Weiteres Material wird erst dann zur Verfügung gestellt, wenn die vorherige Portion verdampft worden ist. Dadurch ist das zu verdampfende Material nur für eine kurze Zeit der Verdampfungstemperatur ausgesetzt.

Vorteilhaft ist auch, dass die benachbarten Verdampfer stufenlos angesteuert werden, wodurch der Verdampfungsprozess ohne Unterbrechung kontinuierlich abläuft.

Ein Ausführungsbeispiel der Erfindung ist in den Zeichnungen dargestellt und wird nachfolgend näher erläutert. Es zeigen:
Fig. 1 einen Ausschnitt einer Vorrichtung zum Verdampfen von Material mit einem außerhalb der Vakuumkammer angeordneten Verdampferrohr;
Fig. 2 einen Ausschnitt des in Fig. 1 gezeigten Verdampferrohrs nach Schnitt entlang B-B und C-C durch dieses Verdampferrohr;
Fig. 3 eine perspektivische Ansicht einer Verdampfereinheit;
Fig. 4 eine Draufsicht auf den in Fig. 2 gezeigten Ausschnitt des Verdampferrohrs;
Fig. 5 einen Schnitt durch den in Fig. 2 gezeigten Ausschnitt des Verdampferrohrs entlang D-D;
Fig. 6 einen Teilausschnitt des in Fig. 5 dargestellten Verdampferrohrs, nachdem der Schnitt auch durch die Verdampfereinheiten durchgeführt worden ist.

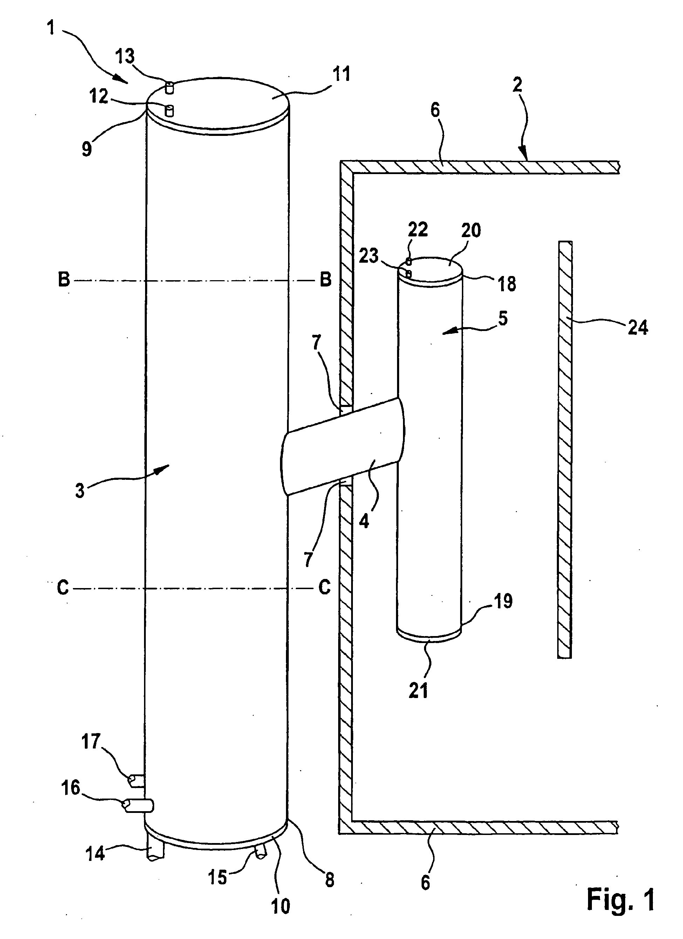

In Fig. 1 ist ein Ausschnitt einer Vorrichtung 1 zum Verdampfen von Material mit einem außerhalb einer Vakuumkammer 2 angeordneten Verdampferrohr 3 gezeigt. Dieses Verdampferrohr 3 ist über ein Verbindungsrohr 4 mit einem innerhalb der Vakuumkammer 2 liegenden Verteiler 5 verbunden. Der Übersicht halber ist von der Vakuumkammer 2 mit der Vakuumkammerwand 6 nur ein Ausschnitt dargestellt, wobei die Vakuumkammer 2 beispielsweise entsprechend der in DE 101 28 091 C1 beschriebenen Vakuumkammer aufgebaut ist.

Damit ein in der Vakuumkammer 2 einmal aufgebauter Druck aufrechterhalten wird, umschließt die Vakuumkammerwand 6 das Verbindungsrohr 4 vollständig. Möglich ist aber auch, dass, wie in Fig. 1 auch dargestellt, zusätzlich um das Verbindungsrohr 4 Dichtungsmaterial 7 angebracht ist. Dadurch wird der in der Vakuumkammer 2 herrschende Druck aufrechterhalten. Das Dichtungsmaterial 7 besteht zum Beispiel aus gummielastischem, Gas undurchlässigem Material.

Das Verdampferrohr 3 ist an den beiden Enden 8, 9 mit Verschlüssen 10, 11 abgeriegelt, z. B. mit Deckeln 10, 11. Diese Deckel 10, 11 verfügen vorzugsweise über mindestens einen Anschluss. So weist der Deckel 11, wie in Fig. 1 dargestellt, zwei Anschlüsse 12, 13 auf. An einem dieser Anschlüsse 12 kann beispielsweise eine Heizung angeschlossen werden, die hier jedoch nicht dargestellt ist. Mit dieser Heizung kann das in dem Verdampferrohr befindliche Material verdampft werden. An den anderen Anschluss 13 kann ein Temperaturfühler angebracht werden, mit dem die in dem Verdampferrohr 3 auftretenden Temperaturverhältnisse überwacht werden können. Der Temperaturfühler ist hier jedoch nicht gezeigt.

Für die Anschlüsse der Heizungen und der Kühlungen der Verdampfereinheiten können Schlitze im Verdampferrohr 3 vorgesehen sein. Die Anschlüsse an den Verdampfereinheiten können nur starr ausgeführt werden, sodass die externen Zuführungen im Vakuum flexibel ausgeführt werden müssen.

Auch der Deckel 10 verfügt über mehrere Anschlüsse 14, 15. Über den Anschluss 14 steht das Verdampferrohr 3 mit einer Steuerung in Verbindung. An dem Anschluss 15 kann eine Vakuumpumpe angebracht sein, mit der in dem Verdampferrohr 3 ein Vakuum erzeugt werden kann, sodass dort vor dem Verdampfungsprozess vorzugsweise ein Druck herrscht, der dem in der Vakuumkammer 2 entspricht. Eine Vakuumpumpe ist jedoch der Übersicht halber nicht dargestellt.

Aber auch das Verdampferrohr 3 kann über mehrere Anschlüsse verfügen. So sind in Fig. 1 zwei direkt am Verdampferrohr 3 angeordnete Anschlüsse 16, 17 zu sehen. Diese Anschlüsse 16, 17 dienen dazu, das Verdampferrohr 3 bei Bedarf mit Kühlmittel, z. B. Wasser, zu versorgen. Dabei dient der Anschluss 16 beispielsweise als Kühlmittelauslass und der Anschluss 17 als Kühlmitteleinlass.

Wie das Verdampferrohr 3 ist auch der Verteiler 5 an seinen beiden Enden 18, 19 verschlossen. Dies kann beispielsweise über Verschlüsse 20, 21, z. B. Deckel 20, 21, geschehen. Dabei können auch diese Deckel 20, 21 mit Anschlüssen versehen sein, wobei in Fig. 1 nur zwei Verschlüsse 22, 23 zu erkennen sind, die am Deckel 20 angeordnet sind. Über diese Verschlüsse 22, 23 kann der Verteiler 5 beispielsweise mit einer Heizung in Verbindung stehen, sodass im Verteiler 5 zum Beispiel eine Temperatur herrscht, die der in dem Verteilerrohr 3 herrschenden Temperatur entspricht. Die Anschlüsse 22, 23 können aber auch zur Kühlmittelversorgung oder zur Anbringung eines Temperaturfühlers verwendet werden. Heizung, Temperaturfühler oder die Kühlmittelversorgung sind in Fig. 1 nicht gezeigt.

Der Verteiler 5 verfügt über mindestens eine Öffnung, vorzugsweise über mehrere in einer Reihe angeordnete Öffnungen, die jedoch in Fig. 1 nicht zu sehen sind. Über diese Öffnungen gelangt der Dampf auf das in der Vakuumkammer 2 angeordnete Substrat 24. Dieses Substrat 24 wird an der zumindest einen Öffnung des Verteilers vorbei bewegt, sodass sich der Dampf auf das Substrat 24 zu bewegt und sich dort niederschlägt. Das in Fig. 1 gezeigte Substrat wird dabei in die Bildebene hinein oder aber aus der Bildebene heraus bewegt. Eine solche Bewegung des Substrats vorbei an dem Verteiler ist zum Beispiel in DE 101 28 091 C1 beschrieben.

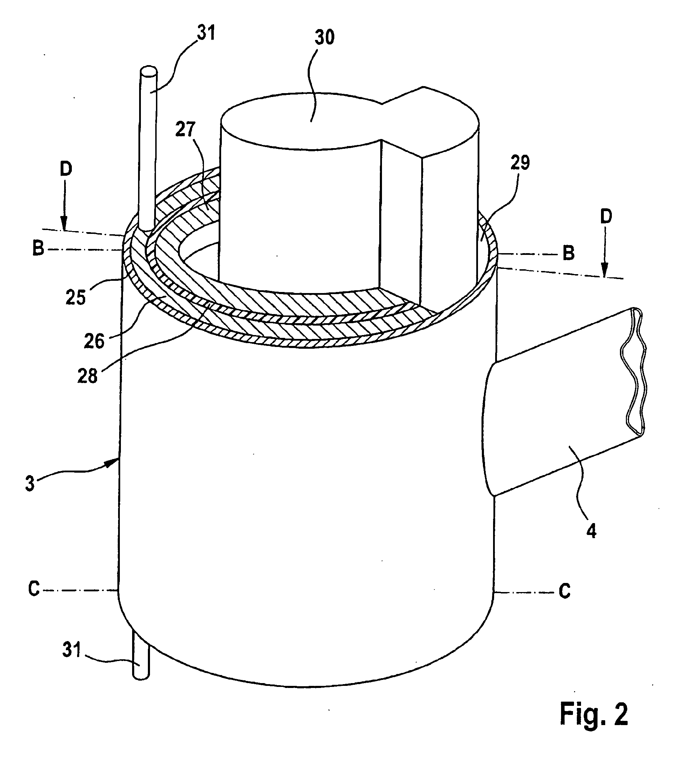

In Fig. 2 ist ein Ausschnitt des in Fig. 1 gezeigten Verdampferrohrs 3 nach Schnitt durch dieses Verdampferrohrs 3 entlang B-B und C-C dargestellt. Im Innern des Verdampferrohrs 3 mit seiner Wandung 25 ist ein Zylinder 26 angeordnet, der direkt an der Wandung 25 anliegt. An dem Zylinder 26 ist eine Verdampfereinheit 27 in Form eines Rings angeordnet, wobei sich zwischen dieser Verdampfereinheit 27 und dem Zylinder 26 eine Isolierschicht 28 befindet. Die Verdampfereinheit 27, der Zylinder 26 sowie die Isolierschicht 28 sind in Richtung des Verbindungsrohrs 4 hin offen.

Durch die Verdampfereinheit 27 sowie den in Richtung des Verbindungsrohrs 4 offenen Bereich 29 verläuft ein innerer Kolben, der in einen oberen und unteren Kolben unterteilt ist. In Fig. 2 ist nur der obere Kolben 30 zu erkennen. Der Zylinder 26 mit der Isolierschicht 28 sowie die Verdampfereinheit 27 sind im Gegensatz zum oberen Kolben 30 nicht fest im Verdampferrohr 3 angeordnet, sondern sind entlang eines Führungsstabes 31 bewegbar. Dabei wird die Bewegung über die mit dem Anschluss 14 (Fig. 1) in Verbindung stehende Steuerung gesteuert.

Da die Verdampfereinheit 27 direkt an dem oberen Kolben 30 angeordnet ist, dient der obere Kolben 30 auch als Führungselement. Die Anordnung bestehend aus Verdampfereinheit 27, Zylinder 26 sowie Isolierschicht 28 kann somit entlang des oberen Kolbens 30 bewegt werden.

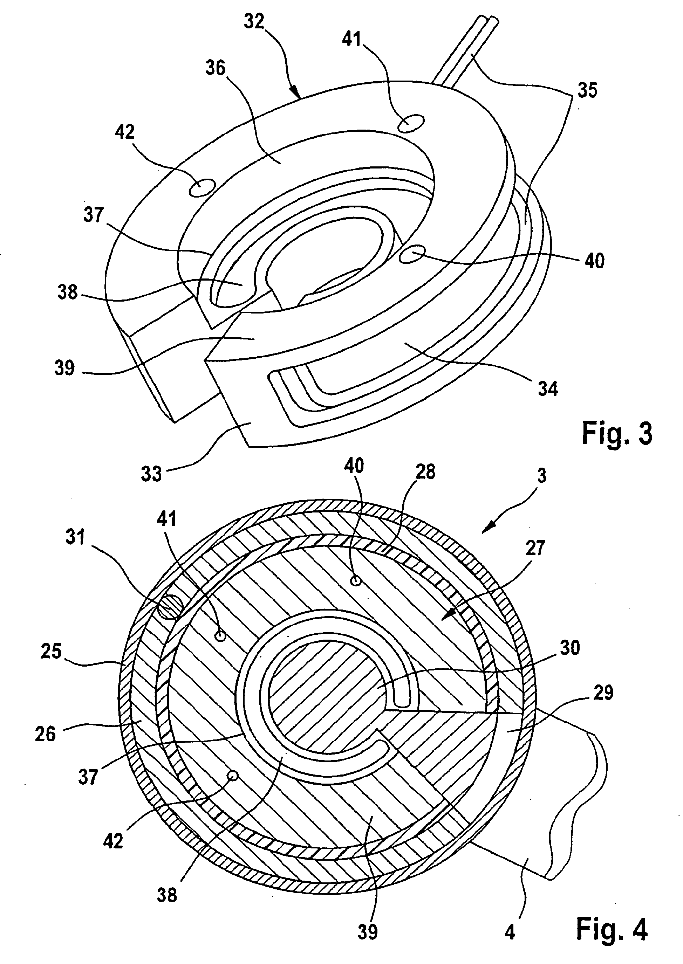

In Fig. 3 ist eine perspektivische Ansicht einer Verdampfereinheit 32, die der Verdampfereinheit 27 entspricht, ohne die sie umgebende Isolierschicht 28 und ohne den Zylinder 26 dargestellt. Die Verdampfereinheit 32, die die Form eines zu einer Seite hin offenen Rings hat, weist an der Außenseite 33 eine Einbuchtung 34 auf, in der eine umlaufende Heizung 35 angeordnet ist. Bei dieser Heizung 35 kann es sich zum Beispiel um einen Heizdraht handeln.

Denkbar ist aber auch, dass ein Heizdraht im Innern der Verdampfereinheit 32 angeordnet ist und sich in der Einbuchtung 34 eine Kühlung befindet. Als Kühlmittel kann Wasser dienen, das natürlich bei Heizungsbetrieb entfernt werden muss. Die Verdampfereinheit verfügt an ihrer Innenseite 36 über eine Wanne 37 zur Aufnahme von zu verdampfendem Material 38, mit welchem das Substrat beschichtet werden soll. Ferner weist die Verdampfereinheit 32 an ihrer Oberseite 39 drei Öffnungen 40, 41, 42 auf. Da die Verdampfereinheit 32 vorzugsweise aus einem Material besteht, welches eine gute Wärmeleitfähigkeit aufweist, wird somit über die Heizung 35 die gesamte Verdampfereinheit 32 auf eine Temperatur gebracht, bei welcher das zu verdampfende Material 38 in den gasförmigen Zustand übergeht.

Fig. 4 zeigt eine Draufsicht auf den in Fig. 2 gezeigten Ausschnitt des Verdampferrohrs 3. Zu erkennen sind die Wandung 25 des Verdampferrohrs 3 sowie der daran angeordnete Zylinder 26 mit der Isolierschicht 28 und der Verdampfereinheit 27. Die Verdampfereinheit 27 weist auf ihrer Oberseite 39 mehrere Öffnungen 40 bis 42 auf. Diese Öffnungen 40 bis 42 dienen zum Fixieren der Isolierschicht 50, 71 bis 79 der Verdampfereinheiten zueinander mittels Stäben. Diese Verdampfereinheiten könnten sich verdrehen, sobald sie im Einsatz sind und die Kolben 30, 80 als Führung nicht zur Verfügung stehen.

Zu erkennen ist auch die Wanne 37 der Verdampfereinheit 27, in der sich das zu verdampfende Material 38 befindet. Die in Richtung des offenen Bereichs 29 hin offene Verdampfereinheit umgibt den oberen Kolben 30. Entlang des Führungsstabs 31 ist es möglich, die an dem Zylinder 26 mit der Isolierschicht 28 angeordnete Verdampfereinheit 27 entlang dem oberen Kolben 30 zu bewegen. Der obere Kolben 30 dient somit als Führungselement.

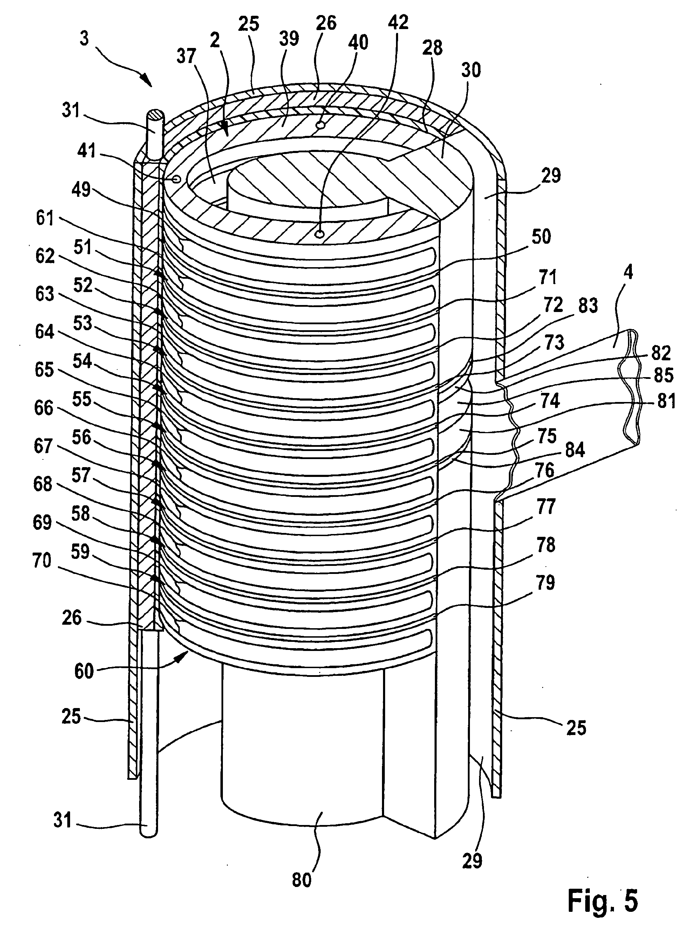

Fig. 5 zeigt einen Schnitt durch den in Fig. 2 gezeigten Ausschnitt des Verdampferrohrs 3 entlang D-D, wobei der Schnitt nur durch die Wandung 25, den Zylinder 26 sowie die Isolierschicht 28 durchgeführt ist. Durch die Verdampfereinheiten 27, 51 bis 60 ist der Schnitt nicht durchgeführt. Zu sehen ist die Wandung 25 des Verdampferrohrs 3. An der Innenseite der Wandung 25 liegt der Zylinder 26 mit der Isolierschicht 28. Dabei ist der Zylinder 26 an dem Führungsstab 31 angeordnet.

Direkt an der Isolierschicht 28 sind Verdampfereinheiten 27, 51 bis 60 angeordnet, die jeweils über Heizelemente 49, 61 bis 70 verfügen, die an den Außenseiten bis 60 angebracht sind. Zwischen den Verdampfereinheiten 27, 51 bis 60 liegt jeweils eine Isolierschicht 50, 71 bis 79.

Jede Verdampfereinheit 27, 51 bis 60 weist eine Wanne auf, in der sich das zu verdampfende Material befindet. Zu erkennen ist jedoch lediglich die Wanne 47 der Verdampfereinheit 27, in der das zu verdampfende Material 48 bereitgestellt wird. Die Verdampfereinheiten 27, 51 bis 60 liegen an dem oberen Kolben 30 und an dem unteren Kolben 80 an. Beide Kolben 30, 80 dienen als Führungselemente für die Verdampfereinheiten 27, 51 bis 60. Der Zylinder 25 kann somit samt den Verdampfereinheiten 27, 51 bis 60 entlang der Führungsstange 31 entweder in Richtung des oberen Kolbens 30 oder des unteren Kolbens 80 bewegt werden.

Der obere sowie der untere Kolben 30, 80 sind jeweils mit einer Heizung 81, 82 versehen, die von dem oberen bzw. unteren Kolben 30, 80 durch eine Isolierung 83, 84 getrennt sind. Zwischen der Heizung 82 des oberen Kolbens 30 und der Heizung 81 des unteren Kolbens 80 ist ein Spalt 85 zu erkennen, durch den das verdampfte Material über den offenen Bereich 29 in das Verbindungsrohr 4 und schließlich über den Verteiler 5 - wie in Fig. 1 dargestellt - auf das Substrat 24 gelangen kann.

Dadurch, dass der untere Kolben 80 und die daran angeordnete Heizung 81 in Richtung des oberen Kolbens 30 hin bzw. her bewegt werden können, kann die Größe des Spalts 85 variiert werden.

Die Verdampfereinheiten sind parallel übereinander angeordnet und entlang einer gedachten gemeinsamen Achse relativ zueinander verschiebbar.

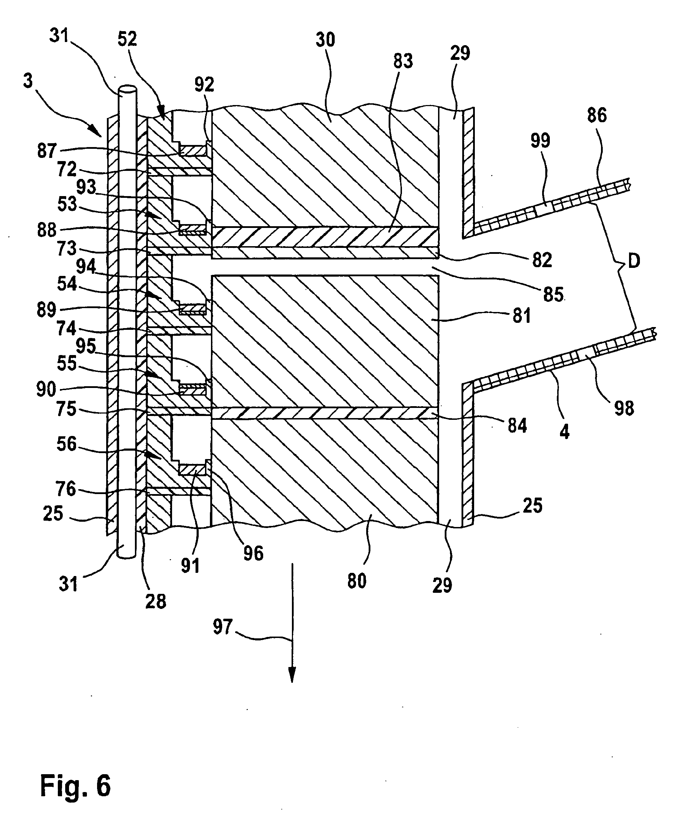

In Fig. 6 ist ein Teilausschnitt des in Fig. 5 dargestellten Verdampferrohrs 3 mit seiner Wandung 25 sowie dem Verbindungsrohr 4 mit seiner Wandung 86 gezeigt, wobei der Schnitt auch durch die Verdampfereinheiten 27, 51 bis 60 geführt ist. Zu erkennen sind lediglich die Verdampfereinheiten 52 bis 56. Durch den Zylinder 26 geht der Führungsstab 31 hindurch, sodass in Fig. 6 der Zylinder 26 nicht erkennbar ist.

An dem Führungsstab 31 sind die Isolierschicht 28 und direkt daran die Verdampfereinheiten 52 bis 56 angeordnet. Die an dem Zylinder 26 angeordneten Verdampfereinheiten 52 bis 56 können so in Richtung des oberen Kolbens 30 oder des unteren Kolbens 80 bewegt werden. Die Verdampfereinheiten 52 bis 56 weisen jeweils Wannen 92 bis 96 auf, in denen sich das zu verdampfende Material 87 bis 91 befindet.

Obwohl die Verdampfereinheiten 52 bis 56 als Ringe mit Wannen 92 bis 96 bezeichnet worden sind, können diese Verdampfereinheiten 52 bis 56 auch eine andere Form aufweisen. Wichtig ist nur, dass diese dann ebenfalls über eine Möglichkeit zur Aufnahme von zu verdampfendem Material sowie eine Heizung verfügen. '

Da die Verdampfereinheiten 52 bis 56 jeweils mit einer Heizung sowie eventuell einer Kühlvorrichtung versehen sind und dadurch, dass die Verdampfereinheiten 52 bis 56 durch Isolierschichten 72 bis 76 voneinander getrennt sind, kann jede Verdampfereinheit 52 bis 56 separat beheizt werden. So ist es möglich, lediglich das in der Wanne 94 der Verdampfereinheit 54 befindliche Material 89 zu verdampfen. Dieses gelangt dann über den Spalte 85 in den Bereich 29. Von diesem Bereich 29 kann der Dampf schließlich über den Verteiler 5 (Fig. 1) in Richtung des Substrats 24 wandern. Die Heizungen 81, 82 des oberen Kolbens 30 und des unteren Kolbens 80 verhindern, dass der Dampf bereits dort kondensiert.

Obwohl nicht dargestellt, kann natürlich auch das Verbindungsrohr 4 mit Heizelementen ausgestattet sein, damit dort eine Kondensation des Dampfs verhindert wird.

Dadurch, dass die Verdampfereinheiten 52 bis 56 direkt am oberen bzw. unteren Kolben 30, 80 anliegen und dadurch, dass zwischen den Verdampfereinheiten Isoliermaterial angeordnet ist, hat der Dampf nur die Möglichkeit, über den Spalt 85 in Richtung des Verbindungsrohrs 4 zu entweichen.

Soll nun nicht nur das Material 89 aus der Wanne 94 der Verdampfereinheit 54 verdampft werden, so kann der untere Kolben 80 in Richtung des Pfeils 97 bewegt werden, sodass der Spalt 85 vergrößert wird. Wird der untere Kolben 80 zum Beispiel um eine Länge D in Richtung des Pfeils 97 bewegt, wobei D dem Innendurchmesser des Verbindungsrohrs 4 entspricht, so kann auch das Material 90 der Verdampfereinheit 55 aus dem nun um D vergrößerten Spalt entweichen. Dabei ist von Vorteil, dass die Verdampfereinheiten 52 bis 56 jeweils über eine eigene Heizung verfügen. So können die Verdampfereinheiten einzeln beheizt werden, und zwar nur diejenigen Verdampfereinheiten, die im Bereich des Spaltes 86 liegen.

Damit muss nicht mehr das gesamte in dem Verdampferrohr 3 befindliche Material erhitzt werden, sondern nur das Material in denjenigen Verdampfereinheiten, die direkt am Spalt liegen. Das Material liegt somit portioniert vor und wird deshalb auch nur portioniert erhitzt. Dies hat den Vorteil, dass Material, welches einer langen thermischen Belastung nicht Stand hält und folglich aufgrund dieser Belastung zerfällt, nur für kurze Zeit der hohen Temperatur ausgesetzt ist.

Wie man aus Fig. 6 erkennt, ist es möglich, dass lediglich das in der Wanne 94 der Verdampfereinheit 54 befindliche Material 89 verdampft wird. Ist das Material 89 verdampft, so wird eine andere Verdampfereinheit, in der sich noch Material befindet, in die Position der Verdampfereinheit 54 bewegt und das in dieser Verdampfereinheit befindliche Material verdampft.

Vorteilhafterweise wird nicht erst gewartet, bis das Material 89 aus der Verdampfereinheit 54 komplett verdampft ist. Um einen kontinuierlichen Prozess mit konstanter Verdampferrate zu gewährleisten, wird vorzugsweise ein Messgerät verwendet, mit dem die Verdampferrate bestimmt werden kann.

Zum Beispiel ist es möglich, durch IR-Messungen die Konzentration an dem verdampften Material zu bestimmen, indem das Verbindungsrohr 4 als Messzelle dient, wobei das Verbindungsrohr 4 zwei gegenüberliegende Fenster 98, 99 aufweist, durch die IR-Lichtstrahlung hindurchgeschickt wird. Über das mathematische Verfahren der Chemometrie kann dann die Konzentration des dampfförmigen Materials bestimmt werden.

Unterschreitet die Konzentration einen bestimmten Wert, so wird eine andere Verdampfereinheit in die Position der Verdampfereinheit 54 gebracht und das in dieser Verdampfereinheit befindliche Material verdampft.

Soll die Verdampferrate erhöht werden, so ist dies zum einen durch die Erhöhung der Verdampfungstemperatur und zum anderen durch eine Vergrößerung des Spalts 85 möglich. Durch die Vergrößerung des Spalts 85 liegen nun noch weitere Verdampfereinheiten im Bereich des Spalts 85, wodurch auch das in diesen Verdampfereinheiten befindliche Material verdampft werden kann. Je nach der Größe des Spalts sind auch unterschiedlich viele Verdampfereinheiten ausgewählt und damit auch die Menge an zu verdampfendem Material, wodurch eine fein gestufte Ratenregelung möglich ist.

Durch diese Verdampfereinheiten mit nur einer bestimmten Menge an Material muss nicht mehr das gesamte in dem Verdampferrohr 3 befindliche Material verdampft werden. Dadurch sind die portionierten Mengen an Material in den jeweiligen Verdampfereinheiten nur relativ kurze Zeit den hohen Temperaturen ausgesetzt, wodurch das Material verdampft worden ist, bevor es aufgrund der thermischen Belastung zerfallen kann.

Durch diese große Anzahl an Verdampfereinheiten, die über das Führungselement in die für die Verdampfung von Material richtige Position gebracht werden können, kann dem Verdampfungsprozess kontinuierlich Material zur Verfügung gestellt werden. Damit ist eine konstante Verdampferrate ständig gewährleistet. Die Standzeit der Gesamtanlage ist dementsprechend auch lang genug, um auch große Flächen zu beschichten.

Grundsätzlich sind zwei voneinander unabhängige Bewegungen relativ zu dem an der Anlage fixierten Verdampferrohr 3 zu unterscheiden.

Bei der einen Bewegung, welche sich auf den Kolben 30 oder den Kolben 80 bezieht, ist einer der beiden Kolben an dem Verdampferrohr 3 fixiert. Der jeweils andere Kolben wird beispielsweise über eine vakuumdichte lineare Schiebeführung von außerhalb des Vakuums angetrieben. Welcher der beiden Kolben 30, 80 fixiert ist und welcher beweglich ist, hat auf die Funktion keinen Einfluss.

Die andere Bewegung, welche die Bewegung der Verdampfereinheiten betrifft, kann ebenfalls über vakuumdichte Schiebeführungen erfolgen, die von außerhalb des Vakuums angetrieben werden. Die Verdampfereinheiten sind über Stäbe in den Öffnungen 40 bis 43 zu einer Einheit, inklusive der Isolierungen, verbunden.

## Patentansprüche

1. Vorrichtung zum Verdampfen von Materialien mit einem Verdampferrohr (3), das wenigstens einen Austritt (85) für das verdampfte Material aufweist, **dadurch gekennzeichnet, dass** wenigstens zwei parallel zueinander angeordnete Verdampfereinheiten (27, 32, 51 - 60) vorgesehen sind, die entlang einer gemeinsamen Achse relativ zueinander bewegbar sind.

2. Vorrichtung nach Anspruch 1, **dadurch gekennzeichnet, dass** die Verdampfereinheiten (27, 32, 51 - 60) mit jeweils eigenen Heizvorrichtungen (49, 61 - 70) versehen sind.

3. Vorrichtung nach Anspruch 1, **dadurch gekennzeichnet, dass** Führungselemente (30, 80) für die Verdampfereinheit (27, 32, 51 - 60) vorgesehen sind, von denen wenigstens ein Führungselement (80) verschiebbar ist.

4. Vorrichtung nach Anspruch 3, **dadurch gekennzeichnet, dass** die Führungselemente (30, 80) Kolben sind, die von den Verdampfereinheiten (27, 32, 51 - 60) zumindest teilweise zangenartig umgeben sind.

5. Vorrichtung zum Verdampfen von Materialien nach Anspruch 1, **dadurch gekennzeichnet, dass** die zumindest zwei Verdampfereinheiten (27, 32, 51 - 60) an einem Zylinder (26) angeordnet sind, der an der Innenseite der Wandung (25) des Verdampferrohrs (3) anliegt.

6. Vorrichtung zum Verdampfen von Materialien nach Anspruch 5, **dadurch gekennzeichnet, dass** zwischen dem Zylinder (26) und den an dem Zylinder (26) angeordneten zumindest zwei Verdampfereinheiten (27, 32, 51 - 60) Isoliermaterial (28) angeordnet ist.

7. Vorrichtung zum Verdampfen von Materialien nach Anspruch 1, **dadurch gekennzeichnet, dass** zwischen den zumindest zwei Verdampfereinheiten (27, 32, 51 - 60) Isoliermaterial (50, 71 - 79) angeordnet ist.

8. Vorrichtung zum Verdampfen von Materialien nach Anspruch 1, **dadurch gekennzeichnet, dass** die zumindest zwei Verdampfereinheiten (27, 32, 51 - 60) mindestens eine Aufnahmemöglichkeit (37, 47, 92 - 96) für zu verdampfendes Material aufweisen.

9. Vorrichtung zum Verdampfen von Materialien nach Anspruch 1, **dadurch gekennzeichnet, dass** jede der zumindest zwei Verdampfereinheiten (27, 32, 51 - 60) über eine separate Heizung verfügt.

10. Vorrichtung zum Verdampfen von Materialien nach Anspruch 1, **dadurch gekennzeichnet, dass** jede der zumindest zwei Verdampfereinheiten (27, 32, 51 - 60) über eine separate Kühlung verfügt.

11. Vorrichtung zum Verdampfen von Materialien nach Anspruch 1, **dadurch gekennzeichnet, dass** die zumindest zwei Verdampfereinheiten mit einem Führungsstab (31) in Verbindung stehen.

12. Vorrichtung zum Verdampfen von Materialien nach Anspruch 5 und 11, **dadurch gekennzeichnet, dass** der Zylinder (26) mit dem Führungsstab (31) in Verbindung steht.

13. Vorrichtung zum Verdampfen von Materialien nach Anspruch 1, **dadurch gekennzeichnet, dass** die Verdampfereinheiten (27, 32, 51 - 60) zu einer Seite hin offene Ringe sind.

14. Vorrichtung zum Verdampfen von Materialien nach Anspruch 13, **dadurch gekennzeichnet, dass** die zu einer Seite hin offenen Verdampfereinheiten (27, 32, 51 - 60) den oberen Kolben (30) und/oder den unteren Kolben (80) zangenartig umgeben.

15. Vorrichtung zum Verdampfen von Materialien nach Anspruch 1, **dadurch gekennzeichnet, dass** zumindest eine der Verdampfereinheiten (27, 32, 51 - 60) in Höhe des Spalts (85) angeordnet ist.

16. Vorrichtung zum Verdampfen von Materialien nach Anspruch 1, **dadurch gekennzeichnet, dass** der Spalt (85) durch eine an dem oberen Kolben (30) angeordnete Heizung (82) und eine an dem unteren Kolben (80) angeordnete Heizung (81) gebildet wird.

17. Vorrichtung zum Verdampfen von Materialien nach Anspruch 16, **dadurch gekennzeichnet, dass** zwischen dem unteren Kolben (80) und der Heizung (81) sowie dem oberen Kolben (30) und der Heizung (82) Isoliermaterial (83, 84) angeordnet ist.

18. Vorrichtung zum Verdampfen von Materialien nach Anspruch 1, **dadurch gekennzeichnet, dass** zwischen dem Verdampferrohr (3) und dem Verteiler (5) ein Verbindungsrohr (4) angeordnet ist.

## Claims

1. Device for the vaporization of materials with a vaporizer tube (3) which includes at least one discharge (85) for the vaporized material, **characterized in that** at least two vaporizer units (27, 32, 51 - 60) disposed in parallel are provided, which are movable along a common axis relative to one another.

2. Device as claimed in claim 1, **characterized in that** the vaporizer units (27, 32, 51 - 60) are each provided with its own heating device (49, 61 - 70).

3. Device as claimed in claim 1, **characterized in that** guide elements (30, 80) for the vaporizer unit (27, 32, 51 - 60) are provided, of which at least one guide element (80) is displaceable.

4. Device as claimed in claim 3, **characterized in that** the guide elements (30, 80) are pistons which are at least partially encompassed by the vaporizer units (27, 32, 51 - 60) in the form of tongs.

5. Device for the vaporization of materials as claimed in claim 1, **characterized in that** the at least two vaporizer units (27, 32, 51 - 60) are disposed on a cylinder (26) which is in contact on the internal side of the wall (25) of the vaporizer tube (3).

6. Device for the vaporization of materials as claimed in claim 5, **characterized in that** between the cylinder (26) and the at least two vaporizer units (27, 32, 51 - 60) disposed on the cylinder (26) insulation material (28) is disposed.

7. Device for the vaporization of materials as claimed in claim 1, **characterized in that** between the at least two vaporizer units (27, 32, 51 - 60) insulation material (50, 71 - 79) is disposed.

8. Device for the vaporization of materials as claimed in claim 1, **characterized in that** each of the at least two vaporizer units (27, 32, 51 - 60) includes at least one receiving facility (37, 92 - 96) for the material to be vaporized.

9. Device for the vaporization of materials as claimed in claim 1, **characterized in that** each of the at least two vaporizer units (27, 32, 51 - 60) includes a separate heater.

10. Device for the vaporization of materials as claimed in claim 1, **characterized in that** each of the at least two vaporizer units (27, 32, 51 - 60) includes a separate cooling system.

11. Device for the vaporization of materials as claimed in claim 1, **characterized in that** the at least two vaporizer units are connected with a guide rod (31).

12. Device for the vaporization of materials as claimed in claim 5 and 11, **characterized in that** the cylinder (26) is connected with the guide rod (31).

13. Device for the vaporization of materials as claimed in claim 1, **characterized in that** the vaporizer units (27, 32, 51 - 60) are rings open toward one side.

14. Device for the vaporization of materials as claimed in claim 13, **characterized in that** the vaporizer units (27, 32, 51 - 60) open toward one side encompass the upper piston (30) and/or the lower piston (80) in the form of tongs.

15. Device for the vaporization of materials as claimed in claim 1, **characterized in that** at least one of the vaporizer units (27, 32, 51 - 60) is disposed at the level of the gap (85).

16. Device for the vaporization of materials as claimed in claim 1, **characterized in that** the gap (85) is formed by a heater (82) disposed on the upper piston (30) and a heater (81) disposed on the lower piston (80).

17. Device for the vaporization of materials as claimed in claim 16, **characterized in that** between the lower piston (80) and the heater (81) as well as the upper piston (30) and the heater (82) insulation material (83, 84) is disposed.

18. Device for the vaporization of materials as claimed in claim 1, **characterized in that** between the vaporizer tube (3) and the distributor (5) a connection tube (4) is disposed.

## Revendications

1. Dispositif pour l'évaporation de matières avec un tube d'évaporateur (3), comportant au moins une sortie (85) pour la matière évaporée, **caractérisé en ce qu'**au moins deux unités d'évaporateur (27, 32, 51 à 60) disposées en parallèle qui sont mobiles l'une par rapport à l'autre le long d'un axe commun sont prévues.

2. Dispositif selon la revendication 1, **caractérisé en ce que** les unités d'évaporateur (27, 32, 51 à 60) sont munies chacune de propres dispositifs de chauffage (49, 61 à 70).

3. Dispositif selon la revendication 1, **caractérisé en ce que** des éléments de guidage (30, 80) pour l'unité d'évaporateur (27, 32, 51 à 60) sont prévues, dont au moins un élément de guidage (80) est déplaçable.

4. Dispositif selon la revendication 3, **caractérisé en ce que** les éléments de guidage (30, 80) sont des pistons qui sont entourés au moins partiellement à la manière de pinces par les unités d'évaporateurs (27, 32, 51 - 60).

5. Dispositif pour l'évaporation de matières selon la revendication 1, **caractérisé en ce que** les au moins deux unités d'évaporateurs (27, 32, 51 à 60) sont disposées sur un cylindre (26) qui est adjacent à la face intérieure de la paroi (25) du tube d'évaporateur (3).

6. Dispositif pour l'évaporation de matières selon la revendication 5, **caractérisé en ce qu'**entre le cylindre (26) et les au moins deux unités d'évaporateurs (27, 32, 51 à 60) disposées sur le cylindre (26) est disposée de la matière isolante (28).

7. Dispositif pour l'évaporation de matières selon la revendication 1, **caractérisé en ce qu'**entre les au moins deux unités d'évaporateurs (27, 32, 51 à 60) est disposée de la matière isolante (50, 71 à 79).

8. Dispositif pour l'évaporation de matières selon la revendication 1, **caractérisé en ce que** les au moins deux unités d'évaporateurs (27, 32, 51 à 60) comportent au moins une possibilité d'accueil (37, 47, 92 à 96) pour de la matière à évaporer.

9. Dispositif pour l'évaporation de matières selon la revendication 1, **caractérisé en ce que** chacune des aux moins deux unités d'évaporateurs (27, 32, 51 à 60) dispose d'un chauffage séparé.

10. Dispositif pour l'évaporation de matières selon la revendication 1, **caractérisé en ce que** chacune des aux moins deux unités d'évaporateurs (27, 32, 51 à 60) dispose d'un refroidissement séparé.

11. Dispositif pour l'évaporation de matières selon la revendication 1, **caractérisé en ce que** les au moins deux unités d'évaporateurs sont en liaison avec une barre de guidage (31).

12. Dispositif pour l'évaporation de matières selon la revendication 5 et 11, **caractérisé en ce que** le cylindre (26) est en liaison avec la barre de guidage (31).

13. Dispositif pour l'évaporation de matières selon la revendication 1, **caractérisé en ce que** les unités d'évaporateurs (27, 32, 51 à 60) sont des bagues ouvertes sur un côté.

14. Dispositif pour l'évaporation de matières selon la revendication 13, **caractérisé en ce que** les unités d'évaporateurs (27, 32, 51 à 60) ouvertes sur un côté entourent à la manière d'une pince le piston supérieur (30) et/ou le piston inférieur (80).

15. Dispositif pour l'évaporation de matières selon la revendication 1, **caractérisé en ce qu'**au moins l'une des unités d'évaporateurs (27, 32, 51 à 60) est disposée au niveau de l'interstice (85).

16. Dispositif pour l'évaporation de matières selon la revendication 1, **caractérisé en ce que** l'interstice (85) est formé par un chauffage (82) disposé sur le piston supérieur (30) et par un chauffage (81) disposé sur le piston inférieur (80).

17. Dispositif pour l'évaporation de matières selon la revendication 16, **caractérisé en ce qu'**entre le piston inférieur (80) et le chauffage (81) ainsi qu'entre le piston supérieur (30) et le chauffage (82) est disposée de la matière isolante (83, 84).

18. Dispositif pour l'évaporation de matières selon la revendication 1, **caractérisé en ce qu'**entre le tube d'évaporateur (3) et le distributeur (5) est disposé un tube de liaison (4).
